# EUROPÄISCHE PATENTSCHRIFT

(11) **EP 1 859 479 B1**
(45) Veröffentlichungstag und Bekanntmachung des Hinweises auf die Patenterteilung: **11.02.2009**
(21) Anmeldenummer: 06723328.8
(22) Anmeldetag: 09.03.2006
(51) Int. Cl.: H01L 21/304, B24C 1/00

(54) **VERAHREN ZUR MIKROSTRUKTURIERUNG VON FESTKÖRPEROBERFLÄCHEN**
METHOD FOR MICROSTRUCTURING SOLID SURFACES
PROCEDE POUR MICROSTRUCTURER DES SURFACES DE SOLIDES

(30) Priorität: 16.03.2005 DE 102005012490; 25.01.2006 DE 102006003604
(43) Veröffentlichungstag der Anmeldung: 28.11.2007
(73) Patentinhaber: Fraunhofer-Gesellschaft zur Förderung der angewandten Forschung e.V., 80686 München (DE); Johann Wolfgang Goethe-Universität Frankfurt am Main, 60325 Frankfurt am Main (DE)
(72) Erfinder: MAYER, Kuno, 79114 Freiburg (DE); KRAY, Daniel, 79112 Freiburg (DE); KOLBESEN, Bernd, O., 61350 Bad Homburg (DE); HOPMAN, Sybille, 77972 Mahlberg (DE)
(74) Vertreter: Riepe, Hans-Gerd
(86) Internationale Anmeldenummer: PCT/EP2006/002193
(87) Internationale Veröffentlichungsnummer: WO 2006/097241

(56) Entgegenhaltungen:
- EP-A- 1 053 831
- EP-A- 1 221 357

## Beschreibung

Die Erfindung betrifft ein Verfahren zur Mikrostrukturierung von Festkörperoberflächen durch chemisches oder elektrochemisches Ätzen, bei dem die Festkörperoberfläche mit einem Ätzfluid unter Bildung von im Ätzfluid unlöslichen oder gering löslichen Zwischenprodukten behandelt wird. Durch zusätzliche Verwendung eines Partikelstrahls können diese Zwischenprodukte auf einfache Weise entfernt werden. Hiermit verbunden ist der Vorteil, dass eine schädigungsarme Mikrostrukturierung von Festkörpern ermöglicht wird.

In dem Dokument EP-A-1 053 831 wird eine Sandstrahl - verfahren mit einem Chelad-zusatz beschrieben, um eine waferoberfläche zu mikrostrukturienen. Das Dokument EP-A 1 221 357 handelt von einem Reinigugsverfahren für wafer, wobei die Oberfläche mit Kohlendioxid gereinigt wird und danach ein Ätzverfahren stattfindet.

Im Stand der Technik wird die Mikrostrukturierung von Festkörpern in der Regel durch nasschemisches Ätzen realisiert. Die nasschemischen Verfahren sind dabei mit Maskierungsschritten, z.B. einer Photolithographie, verbunden, was diese Verfahren sehr aufwendig und zeitintensiv macht.

Eine weitere Variante im Stand der Technik basiert auf der Laserstrukturierung der Oberfläche in einer reaktiven Atmosphäre, die gasförmig oder flüssig sein kann. Nachteil der Laserstrukturierung ist das hier auftretende Fokussierungsproblem durch den nicht konstanten Brechungsindex sowie die begrenzte Nachführung von Reaktanden und die geringe Abtreibungsgeschwindigkeit der Reaktionsprodukte.

Eine weitere Variante betrifft die Flüssigkeitsstrahl-geführte Laserbearbeitung, die bislang mit Wasser als Medium arbeitet. Durch hochenergetische Laserpulse kommt es hier zu einer Materialverdampfung, die den Materialabtrag ermöglicht. Hiermit verbunden ist allerdings der Nachteil, dass es zu erheblichen mechanischen und thermischen Belastungen bzw. Schädigungen der Festkörperoberfläche kommt.

Ausgehend hiervon war es Aufgabe der vorliegenden Erfindung, ein Mikrostrukturierungsverfahren bereitzustellen, das auf einer schädigungsfreien chemischen bzw. elektrochemischen Behandlung beruht und gleichzeitig eine hohe Prozessgeschwindigkeit erlaubt.

Diese Aufgabe wird durch das Verfahren mit den Merkmalen des Anspruchs 1 gelöst. Die weiteren abhängigen Ansprüche zeigen vorteilhafte Weiterbildungen auf.

Erfindungsgemäß wird ein Verfahren zur Mikrostrukturierung von Festkörperoberflächen durch chemisches oder elektrochemisches Ätzen bereitgestellt, bei dem die Festkörperoberfläche mit einem Ätzfluid unter Bildung von in dem Ätzfluid unlöslichen oder gering löslichen Zwischenprodukten behandelt wird. Erfindungswesentlich ist es nun, dass die gebildeten Zwischenprodukte, die nach den aus dem Stand der Technik bekannten Verfahren nur schwer zu entfernen sind und damit die Prozessgeschwindigkeit reduzieren, durch eine gleichzeitige oder nachgeschaltete tribologische Behandlung der Festkörperoberfläche mit mindestens einem Partikelstrahl entfernt werden.

Durch das erfindungsgemäße Verfahren können die an der Oberfläche durch chemische oder elektrochemische Reaktion entstehenden und eventuell angelagerten Zwischenprodukte, die in der Regel schlecht oder gar nicht im Ätzfluid löslich sind, einfach entfernt werden, was zu einer deutlichen Beschleunigung des Strukturierungsverfahrens führt, die für die Entfernung der Zwischenprodukte der Geschwindigkeitsbestimmende Schritt der Strukturierung ist.

Weiterhin soll bei Behandlung mit dem Partikelstrahl die Bildung einer kompakten Passivierungsschicht, wie sie bei der im Stand der Technik bekannten Verwendung stationärer Ätzmedien auftritt, vermieden werden. So kommt es zu einer Aufrauung der Festkörperoberfläche durch den Partikelstrahl, was die Bildung einer Passivierungsschicht erschwert.

Vorzugsweise besteht der Partikelstrahl aus Nanopartikeln, d.h. Partikeln mit einer Korngröße im Bereich von 1 nm bis 1 µm, besonders bevorzugt im Bereich von 1 nm bis 200 nm. Hinsichtlich der Partikelmaterialien sind alle Materialien einsetzbar, die eine entsprechende tribologische Behandlung des gewählten Festköpers erlauben. Bevorzugte Materialien sind hierbei ausgewählt aus der Gruppe bestehend aus Siliciumdioxid, Aluminiumoxid, insbesondere Korund, Zirkoniumoxid, Siliciumcarbid, Graphit oder Mischungen hiervon.

Eine weitere bevorzugte Variante des erfindungsgemäßen Verfahrens sieht vor, dass die Partikel in dem Ätzfluid dispergiert werden oder mit dem Ätzfluid kolloidale Lösungen bilden.

Um die einzelnen Oberflächenbereiche des Festkörpers mit dem Partikelstrahl abfahren zu können, sieht eine erfindungsgemäße Variante vor, dass der mindestens eine Partikelstrahl über die abzutragenden Bereiche der Festkörperoberfläche geführt wird. Hierzu kann beispielsweise eine Steuerungsvorrichtung eingesetzt werden, die ein zweidimensionales Abfahren der Festkörperoberfläche erlaubt. Alternativ ist es aber auch möglich, dass ein stationärer Partikelstrahl verwendet wird, während der Festkörper bewegt wird.

Grundsätzlich kann der erfindungsgemäße Partikelstrahl in Kombination mit allen aus dem Stand der Technik bekannten Mikrostrukturierungsverfahren eingesetzt werden. Eine bevorzugte Variante sieht hierbei vor, dass als Ätzfluid ein flüssiges Ätzmedium eingesetzt wird. Dieses flüssige Ätzmedium wird dann in Form eines Flüssigkeitsstrahls auf die Festkörperoberfläche gerichtet, wobei der Flüssigkeitsstrahl vorzugsweise laminar ist. Der Durchmesser eines solchen Flüssigkeitsstrahls beträgt dabei vorzugsweise von 10 bis 100 µm.

Wird der beschriebene Flüssigkeitsstrahl eingesetzt, ist es besonders bevorzugt, dass in diesem Flüssigkeitsstrahl ein Laserstrahl eingekoppelt wird. Der eingekoppelte Laserstrahl kann dann im Flüssigkeitsstrahl durch Totalreflexion geführt werden. Die Partikel werden dabei bevorzugt in dem flüssigen Ätzmedium suspendiert und dann, vorzugsweise radial, einer Düseneinheit zugeführt, deren Düsenöffnung auf die Festkörperoberfläche gerichtet ist. Diese Variante stellt eine besonders effiziente Möglichkeit dar, indem Flüssigkeitsstrahl und Partikelstrahl miteinander kombiniert werden.

Nach einer weiteren bevorzugten erfindungsgemäßen Variante kann der Partikelstrahl auch beim Gasphasenätzen eingesetzt werden. Dies ist vor allem dann wichtig, wenn beim Gasphasenätzen nicht-flüchtige Oberflächenschichten entstehen. Durch den Einsatz des erfindungsgemäßen Partikelstrahls kann lokal die Ätzwirkung erhöht werden, indem die nicht-flüchtigen Oberflächenschichten während des Prozesses physikalisch abgetragen werden.

Eine andere bevorzugte erfindungsgemäße Variante sieht vor, dass der erfindungsgemäße Partikelstrahl in Kombination mit elektrochemischen Mikrostrukturierungsverfahren eingesetzt wird. So bildet sich z.B. bei der elektrochemischen Ätzung von Silicium ein schlecht haftendes und teilweise poröses Siliciumdioxid. Diese kann auf einfache Weise und effizient mit Hilfe des Partikelstrahls abgetragen werden.

Als Festkörper können alle mikrostrukturierbaren Materialien eingesetzt werden. Bevorzugt bestehen die Festkörper dabei aus Silicium, Glas, Keramik, Kunststoff und/oder deren Verbunden.

Anhand der nachfolgenden Figur soll eine Variante des erfindungsgemäßen Verfahrens näher erläutert werden, ohne dieses auf die hier gezeigten Ausführungsformen einschränken zu wollen.

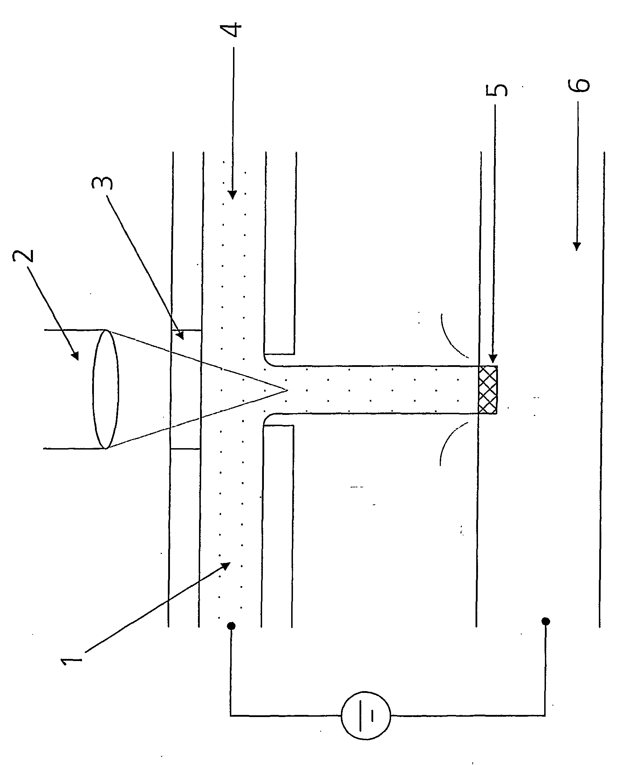

Die Figur zeigt eine Darstellung einer Variante des erfindungsgemäßen Verfahrens, die auf einer elektrochemischen Ätzung basiert.

In der Figur wird ein Festkörper 1, z.B. Silicium, mit einem Flüssigkeitsstrahl geführten Laser behandelt. Zwischen Festkörper 1 und dem Flüssigkeitsstrahl 2 wird hier eine Gleichspannung 3 angelegt. Der Flüssigkeitsstrahl 2 wird dabei durch eine Düseneinheit 4 geführt. Diese weist auf der dem Festkörper abgewandten Seite ein Fenster 5 auf, durch das das Licht in einer Laserquelle 6 eingekoppelt werden kann. Durch den hier beschriebenen Aufbau wird das Aufwachsen eines anodischen Oxids ermöglicht. Der Zusatz von Nanopartikeln, z.B. Zirkoniumoxid, zum Flüssigkeitsstrahl führt zu einer fortlaufenden Entfernung des Oxids während des Prozessablaufs, sodass sich keine kompakte Passivierungsschicht auf dem Festkörper bilden kann. Ohne Zusatz derartiger Partikel käme es schnell zu einer Bedeckung der Oberfläche mit dem Oxid, wodurch die Reaktion zum Erliegen käme.

## Patentansprüche

1. Verfahren zur Mikrostrukturierung von Festkörperoberflächen durch chemisches oder elektrochemisches Ätzen, bei dem die Festkörperoberfläche mit einem flüssigen Ätzmedium unter Bildung von im flüssigen Ätzmedium unlöslichen Zwischenprodukten behandelt wird,
wobei die Zwischenprodukte durch eine gleichzeitige oder nachgeschaltete tribologische Behandlung der Festkörperoberfläche mit mindestens einem Partikelstrahl entfernt werden,
**dadurch gekennzeichnet, dass** das flüssige Ätzmedium als Flüssigkeitsstrahl auf die Festkörperoberfläche gerichtet wird.

2. Verfahren nach Anspruch 1,
**dadurch gekennzeichnet, dass** die Partikel eine Korngröße im Bereich von 1 nm bis 1 µm, insbesondere von 1 nm bis 200 nm aufweisen.

3. Verfahren nach einem der vorhergehenden Ansprüche,
**dadurch gekennzeichnet, dass** die Partikel aus einem Material ausgewählt aus der Gruppe bestehend aus Siliciumdioxid, Aluminiumoxiden, insbesondere Korund, Zirkoniumoxid, Siliciumcarbid, Graphit oder Mischungen hiervon ausgewählt sind.

4. Verfahren nach einem der vorhergehenden Ansprüche,
**dadurch gekennzeichnet, dass** die Partikel in dem flüssigen Ätzmedium dispergiert werden oder mit dem flüssigen Ätzmedium kolloidale Lösungen bilden.

5. Verfahren nach einem der vorhergehenden Ansprüche,
**dadurch gekennzeichnet, dass** der mindestens eine Partikelstrahl über die abzutragenden Bereiche der Festkörperoberfläche geführt wird.

6. Verfahren nach einem der Ansprüche 1 bis 4, **dadurch gekennzeichnet, dass** mindestens ein stationärer Partikelstrahl eingesetzt wird und der Festkörper in Relation zum Partikelstrahl bewegt wird.

7. Verfahren nach dem vorhergehenden Anspruch, **dadurch gekennzeichnet, dass** der Flüssigkeitsstrahl laminar ist.

8. Verfahren nach einem der vorhergehenden Ansprüche,
**dadurch gekennzeichnet, dass** der Flüssigkeitsstrahl einen Durchmesser im Bereich von 10 bis 100 µm aufweist.

9. Verfahren nach einem der vorhergehenden Ansprüche,
**dadurch gekennzeichnet, dass** in den Flüssigkeitsstrahl ein Laserstrahl eingekoppelt wird.

10. Verfahren nach dem vorhergehenden Anspruch, **dadurch gekennzeichnet, dass** der Laserstrahl im Flüssigkeitsstrahl durch Totalreflexion geführt wird.

11. Verfahren nach einem der vorhergehenden Ansprüche,
**dadurch gekennzeichnet, dass** die Partikel in dem flüssigen Ätzmedium suspendiert werden.

12. Verfahren nach einem der vorhergehenden Ansprüche,
**dadurch gekennzeichnet, dass** der Festkörper ausgewählt ist aus der Gruppe bestehend aus Silicium, Glas, Keramik, Kunststoff und deren Verbunden.

## Claims

1. Method for microstructuring solid surfaces by chemical or electrochemical etching, in which the solid surface is treated with a liquid etching medium with formation of intermediate products which are insoluble in the liquid etching medium,
the intermediate products being removed by simultaneous or subsequent tribological treatment of the solid surface with at least one particle stream,
**characterised in that** the liquid etching medium is directed towards the solid surface as a liquid jet.

2. Method according to claim 1,
**characterised in that** the particles have a particle size in the range of 1 nm to 1 µm, in particular from 1 nm to 200 nm.

3. Method according to one of the preceding claims,
**characterised in that** the particles are selected from a material from the group consisting of silicon dioxide, aluminium oxides, in particular corundum, zirconium oxide, silicon carbide, graphite or mixtures thereof.

4. Method according to one of the preceding claims,
**characterised in that** the particles are dispersed in the liquid etching medium or form colloidal solutions with the liquid etching medium.

5. Method according to one of the preceding claims,
**characterised in that that** the at least one particle stream is guided over the regions of the solid surface to be removed.

6. Method according to one of the claims 1 to 4,
**characterised in that** at least one stationary particle stream is used and the solid body is moved in relation to the particle stream.

7. Method according to the preceding claim,
**characterised in that** the liquid jet is laminar.

8. Method according to one of the preceding claims, **characterised in that** the liquid jet has a diameter in the range of 10 to 100 µm.

9. Method according to one of the preceding claims, **characterised in that** a laser beam is coupled to the liquid jet.

10. Method according to the preceding claim,
**characterised in that** the laser beam is guided by total reflection in the liquid jet.

11. Method according to one of the preceding claims, **characterised in that** the particles are suspended in the liquid etching medium.

12. Method according to one of the preceding claims, **characterised in that** the solid body is selected from the group consisting of silicon, glass, ceramic, plastic material and composites thereof.

## Revendications

1. Procédé pour microstructurer des surfaces de solides par gravure chimique ou électrochimique, dans lequel la surface d'un solide est traitée avec un milieu corrosif liquide en formant des produits intermédiaires insolubles dans le milieu corrosif liquide,
dans lequel les produits intermédiaires sont éliminés par un traitement tribologique simultané ou postérieur de la surface du solide avec au moins un faisceau de particules, **caractérisé en ce que** le milieu corrosif liquide est dirigé sous la forme d'un jet de liquide sur la surface du solide.

2. Procédé selon la revendication 1, **caractérisé en ce que** les particules présentent une taille granulaire dans la plage de 1 nm à 1 µm, en particulier de 1 nm à 200 nm.

3. Procédé selon l'une quelconque des revendications précédentes, **caractérisé en ce que** les particules sont constituées d'un matériau choisi dans le groupe constitué du dioxyde de silicium, des oxydes d'aluminium, en particulier le corindon, de l'oxyde de zirconium, du carbure de silicium, du graphite ou de leurs mélanges.

4. Procédé selon l'une quelconque des revendications précédentes, **caractérisé en ce que** les particules sont dispersées dans le milieu corrosif liquide ou forment des solutions colloïdales avec le milieu corrosif liquide.

5. Procédé selon l'une quelconque des revendications précédentes, **caractérisé en ce que** le au moins un faisceau de particules est guidé sur des zones à dénuder de la surface du solide.

6. Procédé selon l'une quelconque des revendications 1 à 4, **caractérisé en ce que** l'on utilise au moins un faisceau de particules stationnaire et **en ce que** le solide est déplacé par rapport au faisceau de particules.

7. Procédé selon la revendication précédente, **caractérisé en ce que** le jet de liquide est laminaire.

8. Procédé selon l'une quelconque des revendications précédentes, **caractérisé en ce que** le jet de liquide présente un diamètre dans la plage de 10 à 100 µm.

9. Procédé selon l'une quelconque des revendications précédentes, **caractérisé en ce qu'**un rayon laser est injecté dans le jet de liquide.

10. Procédé selon la revendication précédente, **caractérisé en ce que** le rayon laser est guidé dans le jet de liquide par réflexion totale.

11. Procédé selon l'une quelconque des revendications précédentes, **caractérisé en ce que** les particules sont mises en suspension dans le milieu corrosif liquide.

12. Procédé selon l'une quelconque des revendications précédentes, **caractérisé en ce que** le solide est choisi dans le groupe constitué du silicium, du verre, de la céramique, du plastique et de leurs composés.
